# EUROPÄISCHE PATENTSCHRIFT

(11) **EP 2 687 936 B1**
(45) Veröffentlichungstag und Bekanntmachung des Hinweises auf die Patenterteilung: **24.12.2014**
(21) Anmeldenummer: 13003365.7
(22) Anmeldetag: 03.07.2013
(51) Int. Cl.: G05G 1/08, G05G 5/06, H01H 25/06, H03K 17/98

(54) **Drehknebel-Bedienvorrichtung**
Rotating knob control device
Dispositif de commande à manette rotative

(30) Priorität: 21.07.2012 DE 102012014535
(43) Veröffentlichungstag der Anmeldung: 22.01.2014
(73) Patentinhaber: Diehl AKO Stiftung & Co. KG, 88239 Wangen (DE)
(72) Erfinder: Heimann, Uwe, DE - 88239 Wangen (DE); Prinz, Michael, DE - 88299 Leutkirch (DE)
(74) Vertreter: Diehl Patentabteilung

(56) Entgegenhaltungen:
- DE-A1- 10 255 676
- DE-A1-102005 049 995

## Beschreibung

Die vorliegende Erfindung betrifft eine Drehknebel-Bedienvorrichtung wie bekannt aus DE 102 55 676 A, insbesondere für ein elektrisches Haushaltsgerät.

Bei elektrischen Haushaltsgeräten wie Kochfeldern, Herden, Waschmaschinen, Spülmaschinen und dergleichen besteht der Wunsch, die Bedienblende möglichst geschlossen, d.h. ohne Durchgangsbohrungen und dergleichen zu gestalten. Anstelle von Drucktasten und -schaltern werden daher häufig berührungs- oder annäherungsempfindliche Bedienelemente eingesetzt, die mit einer optischen, induktiven, kapazitiven oder magnetischen Sensoranordnung versehen sind.

Drehknebel wiesen früher ein Bedienelement auf, welches auf einer Schalterwelle drehbar gelagert war, wobei die Schalterwelle durch eine Durchgangsbohrung in der Bedienblende geführt war. Um auch beim Einsatz von Drehknebeln eine geschlossene Bedienblende beibehalten zu können, sind zum Beispiel aus der DE 102 18 294 A1, der DE 10 2004 013 947 B3 und der EP 0 797 227 B1 magnetisch auf der Bedienblende gehaltene Bedienelemente bekannt. Die Drehstellung oder Drehbewegung der Bedienelemente wird in diesen Fällen durch optisch, induktiv, kapazitiv oder magnetisch detektierende Sensoranordnungen erfasst. Die EP 1 045 300 B1 offenbart eine Drehknebel-Bedienvorrichtung, bei welcher das Bedienelement auf einen Kunststoffträger aufgesteckt ist, welcher auf die geschlossene Bedienblende aufgeklebt ist.

Der Erfindung liegt die Aufgabe zugrunde, eine verbesserte Drehknebel-Bedienvorrichtung zu schaffen, die eine geschlossene Bedienblende erlaubt und eine verbesserte Bedienbarkeit durch den Benutzer bietet.

Diese Aufgabe wird gelöst durch eine Drehknebel-Bedienvorrichtung mit den Merkmalen des Anspruchs 1. Besonders bevorzugte Ausgestaltungen und Weiterbildungen der Erfindung sind Gegenstand der abhängigen Ansprüche.

Die Drehknebel-Bedienvorrichtung weist eine Trägerplatte auf einer dem Benutzer abgewandten Seite einer Bedienblende; eine auf der Trägerplatte vorgesehene erste Elektrodenanordnung; ein im Wesentlichen ringförmiges Bedienelement auf einer dem Benutzer zugewandten Seite der Bedienblende; eine an dem Bedienelement vorgesehene zweite Elektrodenanordnung; und eine Halteeinrichtung zum Halten des Bedienelements an der Bedienblende, wobei das Bedienelement um eine im Wesentlichen senkrecht zur Bedienblende verlaufende Rotationsachse drehbar ist. Erfindungsgemäß ist die Drehknebel-Bedienvorrichtung gekennzeichnet durch eine Rasteinrichtung zum Verrasten des Bedienelements relativ zur Bedienblende in mehreren vorgegebenen Drehstellungen.

Die erste Elektrodenanordnung auf der Trägerplatte, vorzugsweise einer Leiterplatte, und die zweite Elektrodenanordnung an dem Bedienelement bilden zusammen eine kapazitive Sensoranordnung zum Erfassen der Drehstellung oder Drehbewegung des Bedienelements relativ zur Bedienblende. Durch diese kapazitive Sensoranordnung ist es möglich, die Bedienblende auch im Bereich der Drehknebel-Bedienvorrichtung geschlossen, d.h. zum Beispiel ohne Durchbrüche, und somit wasserdicht auszubilden. Dies vereinfacht die Herstellung der Bedienblende, erleichtert das Reinigen der Bedienblende, schützt die hinter der Bedienblende angeordneten Komponenten vor Schmutz und Feuchtigkeit und vermeidet verschleißende Kontakte. Wenn weitere Bedienvorrichtungen des elektrischen Haushaltsgerätes als berührungs- oder annäherungsempfindliche Bedienvorrichtungen insbesondere mit kapazitiven Sensoranordnungen ausgebildet sind, so kann für die Drehknebel-Bedienvorrichtung und die weiteren Bedienvorrichtungen einer Trägerplatte bzw. Leiterplatte ein einheitliches Erfassungs- und Auswertekonzept realisiert werden. Dies vereinfacht die Herstellung der Bedienvorrichtungen.

Das ringförmige Bedienelement, welches drehbar an der Bedienblende gehalten ist, ist für den Benutzer des Haushaltsgerätes einfach und intuitiv bedienbar. Das Bedienelement weist senkrecht zur Rotationsachse eine im Wesentlichen ringförmige Querschnittsform auf. Die ringförmige Querschnittsform ist vorzugsweise, aber nicht notwendigerweise im Wesentlichen rotationssymmetrisch (z.B. kreisringförmig). Das Bedienelement hat darüber hinaus auch eine Ausdehnung in Richtung parallel zur Rotationsachse, sodass es auch als hülsen-, buchsen- oder rohrförmig bezeichnet werden kann. Das Bedienelement ist bevorzugt zumindest teilweise als Hohlkörper ausgebildet. Das Bedienelement ist vorzugsweise mit einer optischen und/oder haptischen Markierung versehen, welches dem Benutzer die aktuelle absolute Drehstellung des Bedienelements relativ zur Bedienblende anzeigt.

Die erfindungsgemäße Bedienvorrichtung ist zudem mit einer Rasteinrichtung zum Verrasten des Bedienelements relativ zur Bedienblende in mehreren, d.h. wenigstens zwei vorgegebenen Drehstellungen versehen. In diesen vorgegebenen Drehstellungen des Bedienelements relativ zur Bedienblende befindet sich zugleich die zweite Elektrodenanordnung an dem Bedienelement in vorgegebenen Drehstellungen relativ zur ersten Elektrodenanordnung auf der Trägerplatte. Dies vereinfacht die Auswertung der Messsignale der kapazitiven Sensoranordnung und erhöht so die Genauigkeit der Eingabe durch das Bedienelement.

Die Rastvorrichtung kann zudem eine haptische Rückmeldung an den Benutzer beim Drehen des Bedienelements bewirken. Die Eingabe wird so für den Benutzer verbessert und vereinfacht.

Die erste Elektrodenanordnung und die zweite Elektrodenanordnung bilden zusammen mit der Bedienblende dazwischen, die ein Dielektrikum bildet, einen Kondensator. Bei Annäherung oder Berührung des elektrisch leitfähigen Bedienelements durch einen Finger des Benutzers verändert sich der Kapazitätswert dieses Kondensators, welche Veränderung durch eine geeignete Auswerteschaltung, die mit der ersten Elektrodenanordnung verbunden ist, erfasst und ausgewertet werden kann. Die von der Auswerteschaltung erzeugten Messsignale werden dann an eine Steuerung des Haushaltsgerätes weitergeleitet. Die Auswerteschaltung kann wahlweise in die Steuerung integriert sein. Damit die Bedienblende als Dielektrikum funktioniert, ist sie zumindest im Bereich des Bedienelements bevorzugt im Wesentlichen elektrisch isolierend ausgebildet. In diesem Zusammenhang können eine absolute Drehstellung des Bedienelements, eine Drehstellungsveränderung des Bedienelements und/oder eine Drehrichtung des Bedienelements erfasst und ausgewertet werden.

Der Kapazitätswert des Kondensators hängt darüber hinaus auch von der Positionierung der zweiten Elektrodenanordnung relativ zur ersten Elektrodenanordnung ab. Während die erste Elektrodenanordnung auf der Trägerplatte vorzugsweise mehrere, d.h. zwei, drei, vier bis zu zehn, elf, zwölf und mehr nebeneinander angeordnete Elektroden aufweist, weist die zweite Elektrodenanordnung am Bedienelement vorzugsweise nur wenige, insbesondere nur ein oder zwei Elektroden auf. In den durch die Rasteinrichtung vorgegebenen Drehstellungen des Bedienelements ist eine Elektrode der zweiten Elektrodenanordnung am Bedienelement vorzugsweise im Wesentlichen in Überdeckung mit einer oder mehreren Elektroden der ersten Elektrodenanordnung auf der Trägerplatte und die Auswerteschaltung kann erfassen, um welche der mehreren Elektroden der ersten Elektrodenanordnung es sich jeweils handelt. Zur Verbesserung der Auswertung und damit der Genauigkeit der Eingaben durch das Bedienelement sind die erste und die zweite Elektrodenanordnung vorzugsweise jeweils möglichst nahe an der Bedienblende oder diese sogar berührend angeordnet.

In einer bevorzugten Ausgestaltung der Erfindung weist die erste Elektrodenanordnung auf der Trägerplatte mehrere Elektrodensegmente auf, die im Wesentlichen koaxial zur Rotationsachse des Bedienelements angeordnet sind, und/oder weist die zweite Elektrodenanordnung am Bedienelement wenigstens eine Elektrode auf, die sich im Wesentlichen radial zur Rotationsachse des Bedienelements erstreckt.

Die Halteeinrichtung ist ausgebildet, um das ringförmige Bedienelement an der Bedienblende zu halten, vorzugsweise in radialer Richtung und in axialer Richtung. Die Halteeinrichtung ist dabei so ausgebildet, dass das Bedienelement um eine im Wesentlichen senkrecht zur Bedienblende verlaufende Rotationsachse drehbar ist, vorzugsweise um wenigstens 90°, bevorzugter um wenigstens 180°, noch bevorzugter um 360°. Die Halteeinrichtung ist bevorzugt so ausgebildet, dass die Bedienblende selbst geschlossen ausgebildet bleiben kann. Vorzugsweise ist die Halteeinrichtung an der dem Benutzer zugewandten Seite an der Bedienblende angebracht oder angeformt, bevorzugt in Form eines Haltestiftes, der im Wesentlichen koaxial zur Rotationsachse des Bedienelements ausgebildet und ausgerichtet ist.

In einer bevorzugten Ausgestaltung der Erfindung ist das Bedienelement mittels der Halteeinrichtung lösbar an der Bedienblende gehalten. Auf diese Weise kann das Bedienelement bei Bedarf von der Bedienblende entfernt werden, sodass das Bedienelement und die Bedienblende einfach gereinigt werden können.

Die Rasteinrichtung ist ausgebildet, um das Bedienelement relativ zur Bedienblende in mehreren vorgegebenen Drehstellungen zu verrasten. Die Rastwirkung ist dabei vorzugsweise so eingestellt, dass sie einerseits vom Benutzer leicht überwunden werden kann, um das Bedienelement weiter zu drehen, aber andererseits auch vom Benutzer wahrgenommen werden kann.

Die durch die Rasteinrichtung bewirkte Verrastung des Bedienelements relativ zur Bedienblende erfolgt vorzugsweise im Wesentlichen radial, d.h. in einer

Ebene im Wesentlichen senkrecht zur Rotationsachse des Bedienelements, oder im Wesentlichen axial, d.h. im Wesentlichen parallel zur Rotationsachse des Bedienelements. Die Rasteinrichtung ist vorzugsweise so ausgebildet, dass sie ein Verrasten zwischen dem Bedienelement und der Bedienblende selbst oder zwischen dem Bedienelement und der Halteeinrichtung bewirkt.

Die Drehknebel-Bedienvorrichtung ist vorzugsweise in elektrischen Haushaltsgeräten wie beispielsweise Kochfeldern, Herden, Waschmaschinen, Wäschetrockner, Spülmaschinen und dergleichen einsetzbar. Beispielsweise kann die Drehknebel-Bedienvorrichtung zum Eingeben einer Koch- oder Heizstufe, eines Waschprogrammes, eines Trockenprogrammes, etc. benutzt werden.

In einer bevorzugten Ausgestaltung der Erfindung weist die Rasteinrichtung wenigstens ein elastisches oder elastisch gelagertes Rastelement auf. Vorzugsweise weist die Rasteinrichtung wenigstens eine Feder auf.

In einer weiteren bevorzugten Ausgestaltung der Erfindung weist die erste Elektrodenanordnung auf der Trägerplatte (zusätzlich) eine zentrale Elektrode auf und ist in dem Bedienelement im Wesentlichen koaxial zur Rotationsachse des Bedienelements eine Drucktaste angeordnet, welche im Wesentlichen in Richtung der Rotationsachse des Bedienelements bewegbar ist und an ihrer der Bedienblende zugewandten Seite wenigstens eine Elektrode aufweist. Die zentrale Elektrode der ersten Elektrodenanordnung auf der Trägerplatte bildet zusammen mit der Elektrode an der Drucktaste und der als Dielektrikum wirkenden Bedienblende dazwischen einen Kondensator, dessen Kapazitätswert u.a. von dem Abstand zwischen den Elektroden abhängt, der durch eine Betätigung der Drucktaste verändert werden kann. Beispielsweise kann diese integrierte Drucktaste das Eingeben einer Zusatzfunktion (zum Beispiel als Hauptschalter zum Ein- und Ausschalten eines Kochfeldes oder des Gerätes) ermöglichen. Die Drucktaste ist vorzugsweise mit einer haptischen Rückmeldung bei ihrer Betätigung ausgebildet. Die Drucktaste ist wahlweise gemeinsam mit dem Bedienelement um dessen Rotationsachse drehbar oder drehfest zum Beispiel an der Halteeinrichtung gehalten.

In einer noch weiteren bevorzugten Ausgestaltung der Erfindung ist auf der Trägerplatte wenigstens eine Lichtquelle angeordnet; ist die Bedienblende zumindest teilweise lichtdurchlässig ausgebildet; und ist das Bedienelement zumindest teilweise lichtdurchlässig ausgebildet und/oder enthält wenigstens ein Lichtleitelement. Bei dieser Ausgestaltung der Drehknebel-Bedienvorrichtung kann das Bedienelement hinterleuchtet werden und so zum Beispiel einen Betriebszustand des Haushalsgerätes, eines zugeordneten Kochfeldes, etc. anzeigen.

Gegenstand der Erfindung ist auch ein elektrisches Haushaltsgerät mit wenigstens einer erfindungsgemäßen Drehknebel-Bedienvorrichtung. Bei dem elektrischen Haushaltsgerät handelt es sich vorzugsweise um eine Waschmaschine, einen Wäschetrockner, eine Spülmaschine, einen Herd, ein Kochfeld, einen Mikrowellenofen und dergleichen.

In einer bevorzugten Ausgestaltung der Erfindung ist zudem wenigstens ein berührungs- oder annäherungsempfindliches Bedienelement mit einer kapazitiven Sensoranordnung vorgesehen und ist eine Elektrode der kapazitiven Sensoranordnung auf der gleichen Trägerplatte wie die erste Elektrodenanordnung der Drehknebel-Bedienvorrichtung vorgesehen. Obige sowie weitere Merkmale und Vorteile der Erfindung werden aus der nachfolgenden Beschreibung bevorzugter, nicht-einschränkender Ausführungsbeispiele unter Bezugnahme auf die beiliegenden Zeichnungen besser verständlich. Darin zeigen, zum Teil schematisch:
- Fig. 1: eine perspektivische Draufsicht einer Drehknebel-Bedienvorrichtung gemäß einem ersten Ausführungsbeispiel der vorliegenden Erfindung;
- Fig. 2: eine Schnittansicht der Drehknebel-Bedienvorrichtung von Fig. 1 gemäß Schnitt A-A;
- Fig. 3: eine Schnittansicht der Drehknebel-Bedienvorrichtung von Fig. 1 gemäß Schnitt B-B;
- Fig. 4: eine Draufsicht der ersten Elektrodenanordnung der Drehknebel-Bedienvorrichtung von Fig. 1;
- Fig. 5: eine perspektivische Explosionsdarstellung der Drehknebel-Bedienvorrichtung von Fig. 1;
- Fig. 6: eine perspektivische Draufsicht einer Drehknebel-Bedienvorrichtung gemäß einem zweiten Ausführungsbeispiel der vorliegenden Erfindung;
- Fig. 7: eine Schnittansicht der Drehknebel-Bedienvorrichtung von Fig. 6 gemäß Schnitt A-A;
- Fig. 8: eine Schnittansicht der Drehknebel-Bedienvorrichtung von Fig. 6 gemäß Schnitt B-B; und
- Fig. 9: eine perspektivische Explosionsdarstellung der Drehknebel-Bedienvorrichtung von Fig. 6.

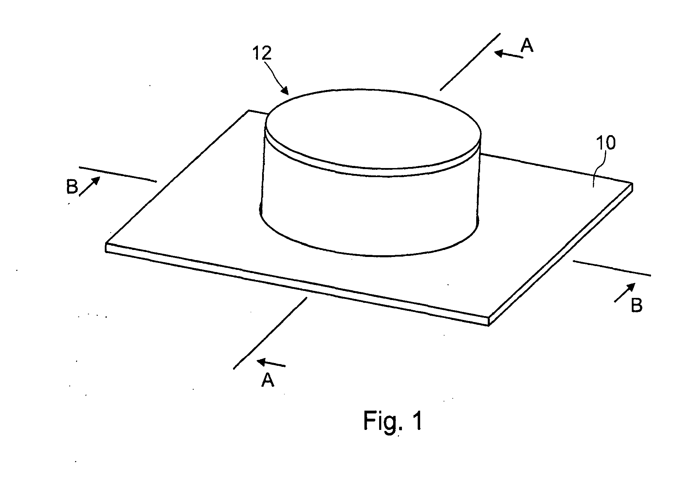

Bezug nehmend auf Fig. 1 bis 5 wird nun ein erstes Ausführungsbeispiel einer erfindungsgemäßen Drehknebel-Bedienvorrichtung näher erläutert. Die Erfindung wird dabei am Beispiel einer Waschmaschine beschrieben.

An einer Bedienblende 10 einer Waschmaschine ist eine Drehknebel-Bedienvorrichtung 12 vorgesehen, mit welcher zum Beispiel eine Vielzahl unterschiedlicher Wasch- und Schleuderprogramme der Waschmaschine eingestellt werden kann.

An der dem Benutzer zugewandten Seite der Bedienblende 10 (oben in den Figuren) ist ein hülsenförmiger Haltestift 14 angeformt oder befestigt, der die Halteeinrichtung der erfindungsgemäßen Drehknebel-Bedienvorrichtung 12 bildet. Die Längsachse dieses Haltestiftes 14 ist koaxial zur Rotationsachse 29 des später beschriebenen Bedienelements 28.

Um diesen Haltestift 14 herum ist in der dem Benutzer zugewandten Seite der Bedienblende 10 außerdem eine kreisförmige Vertiefung 16 ausgebildet. Diese Vertiefung 16 dient als Zwangsführung für das später beschriebene Bedienelement 28. Die Vertiefung 16 ist bevorzugt so ausgestaltet, dass Wasser und Schmutz leicht aus ihr entfernt werden können oder alleine ablaufen können.

Auf den Haltstift 14 ist eine hülsenförmige Rastbuchse 18 gesetzt. Die Rastbuchse 18 ist drehfest mit dem Haltestift 14 verbunden, zum Beispiel durch Presspassung, Verrasten, Verkleben, Verschweißen oder dergleichen. Die Rastbuchse 18 hat in diesem Ausführungsbeispiel auch etwa die gleiche Höhe wie der Haltestift 14, sodass die dem Benutzer zugewandten Enden von Rastbuchse 18 und Haltestift 14 im Wesentlichen zueinander fluchtend ausgerichtet sind.

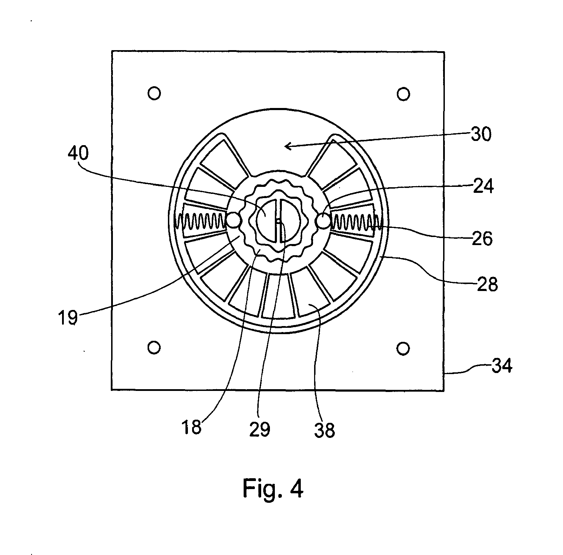

An der Außenmantelfläche der Rastbuchse 18 sind mehrere Rastvertiefungen 19 ausgebildet, die durch Rippen voneinander getrennt sind (siehe insbesondere Fig. 4). Der Rastvertiefungen 19 und die Rippen verlaufen im Wesentlichen parallel zueinander und parallel zur Rotationsachse 29 des Bedienelements 28. In diesem Ausführungsbeispiel verlaufen die Rastvertiefungen 19 außerdem über die gesamte Höhe der Rastbuchse 18, wahlweise können sie sich aber auch nur jeweils über einen vorbestimmten Höhenabschnitt erstrecken.

Alternativ kann die Rastbuchse 18 auch einstückig mit dem Haltestift 14 ausgebildet sein. In diesem Fall sind die Rastvertiefungen 19 direkt an der Außenmantelfläche des Haltestiftes 14 ausgebildet.

Auf den Haltestift 14 mit der Rastbuchse 18 wird sodann ein Führungskörper 20 aufgesetzt. Der Führungskörper 20 hat eine zentrale Ausnehmung, deren Innendurchmesser etwas größer bemessen ist als der Außendurchmesser der Rastbuchse 18, sodass der Führungskörper 20 relativ zu der auf dem Haltstift 14 sitzenden Rastbuchse 18 verdreht werden kann. Der Führungskörper 20 ist zudem mittels eines Federringes in axialer Richtung an dem Haltestift 14 bzw. der Rastbuchse 18 lösbar gehalten, der in eine Außenumfangsnut 22 an der Rastbuchse 18 eingreift.

Der Führungskörper 20 ist im Wesentlichen kreisscheibenförmig ausgebildet. In dem Führungskörper 20 ist zudem wenigstens eine sich in radialer Richtung erstreckende Aufnahme 23 ausgebildet (in diesem Ausführungsbeispiel zwei Aufnahmen 23 diametral gegenüber liegend). Die Aufnahmen 23 sind als Bohrungen ausgebildet, die sich in radialer Richtung vollständig vom Außenumfang bis zum Innenumfang des Führungskörpers 20 durch diesen hindurch erstrecken.

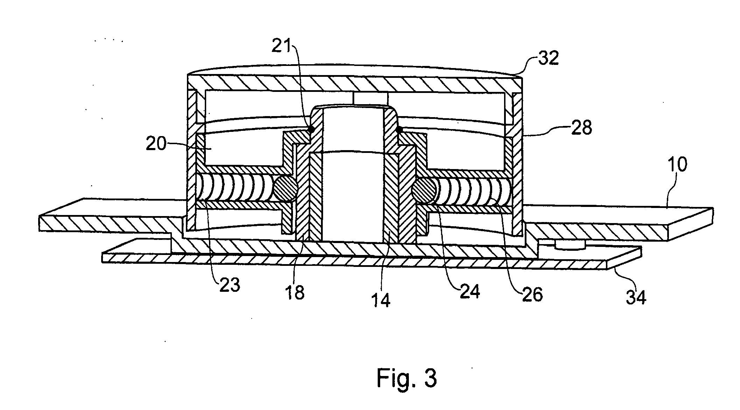

In diese Aufnahmen 23 sind jeweils eine Kugel 24 und eine Feder 26 eingesetzt. Die Kugeln 24 sind dabei am radial inneren Ende der Federn 26 positioniert. Die Kugeln 24 und die Rastvertiefungen 19 der Rastbuchse 18 sind dabei so dimensioniert, dass die Kugeln 24 in bestimmtes Maß in die Rastvertiefungen 19 eingreifen können, wenn die Aufnahmen 23 im Führungskörper 20 in entsprechender Ausrichtung zu den Rastvertiefungen 19 an der Rastbuchse 18 positioniert sind (vgl. Fig. 3 und 4). Die Kugeln 24 sind dabei durch die Federn 26 in Richtung zur Rastbuchse 18 vorgespannt.

Über den Führungskörper 20 ist das ring- bzw. hülsenförmige Bedienelement 28 gesetzt. Während die Bedienblende 10 (zumindest im Bereich des Drehknebels 12), der Haltestift 14, die Rastbuchse 18 und der Führungskörper 20 vorzugsweise aus einem elektrisch nicht leitfähigen Material wie beispielsweise Kunststoff gefertigt sind, kann das Bedienelement 28 aus einem elektrisch leitfähigen Material wie beispielsweise Metall gefertigt oder zumindest mit einer elektrisch leitfähigen Beschichtung versehen.

Das Bedienelement 28 hat einen Innendurchmesser, der etwa dem Außendurchmesser des Führungskörpers 20 entspricht, und ist drehfest mit dem Führungskörper 20 verbunden (z.B. durch Presspassung, Verrasten, Verkleben, Verschweißen, Verschrauben, etc.). Wie in Fig. 3 und 4 erkennbar, stützen sich die Federn 26 in den Aufnahmen 23 des Führungskörpers 20 gegen den Innenumfang des Bedienelements 28 ab und drücken so die Kugeln 24 in radialer Richtung nach innen gegen die Rastbuchse 18.

Außerdem ist der Außendurchmesser des Bedienelements 28 geringfügig kleiner bemessen als der Durchmesser der Vertiefung 16 in der Bedienblende 10. So wird das Bedienelement 28 beim Drehen nicht nur durch den Haltestift 14, sondern auch durch die Vertiefung 16 geführt.

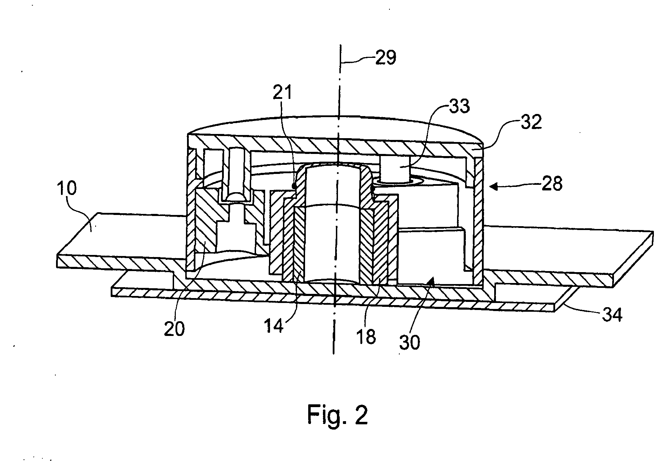

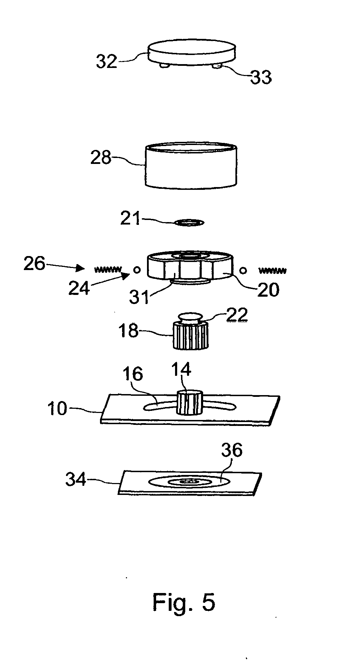

An dem ringförmigen Bedienelement 28 ist zudem eine Elektrode 30 angeformt, die sich vom Innenumfang des Bedienelements 28 im Wesentlichen radial nach innen erstreckt. Die Form der Elektrode 30 ist etwa keilförmig, sich in radialer Richtung nach innen verjüngend. Außerdem reicht die Elektrode 30 nur ein vorbestimmtes Maß radial nach innen, welches deutlich außerhalb des Außendurchmessers der Rastbuchse 18 liegt (vgl. Fig. 2 und 4). In dem Führungskörper 20 ist eine entsprechende Ausnehmung 31 ausgebildet, um diese Elektrode 30 am Bedienelement 28 aufzunehmen (vgl. Fig. 5).

Die Elektrode 30 ist bevorzugt in dem der Bedienblende 10 zugewandten Endbereich des Bedienelements 28 vorgesehen (vgl. Fig. 2 und 5), sodass die Elektrode 30, welche die zweite Elektrodenanordnung der erfindungsgemäßen Drehknebel-Bedienvorrichtung 12 bildet, nahe der Bedienblende 10 angeordnet ist.

Während, wie oben erläutert, das gesamte Bedienelement 28 elektrisch leitfähig ausgebildet oder beschichtet sein kann, ist es auch möglich, nur die Elektrode 30 des Bedienelements 28 elektrisch leitfähig auszubilden oder nur die der Bedienblende 10 zugewandte Unterseite der Elektrode 30 elektrisch leitfähig zu beschichten.

Das dem Benutzer zugewandte Ende des ringförmigen Bedienelements 28 ist mit einer Kappe 32 verschlossen. Die Kappe ist vorzugsweise aus einem elektrisch nicht leitfähigen Material wie beispielsweise Kunststoff gefertigt. Die Kappe 32 ist in diesem Ausführungsbeispiel mittels wenigstens eines Rastzapfens 33 fest auf das Bedienelement 28 gesetzt (alternativ auch durch zum Beispiel Presspassung, Verrasten, Verschrauben, Verschweißen, Verkleben, etc.).

Auf der dem Benutzer abgewandten Seite der Bedienblende 10 (unten in den Figuren) ist eine Trägerplatte 34 vorgesehen. Die Trägerplatte 34 ist im Wesentlichen parallel zur Bedienblende 10 ausgerichtet und bevorzugt als Leiterplatte ausgebildet.

Auf der der Bedienblende 10 zugewandten Seite der Trägerplatte 34 ist auf dieser eine erste Elektrodenanordnung 36 vorgesehen. Wie insbesondere in Fig. 4 zu erkennen, weist diese erste Elektrodenanordnung 36 eine Vielzahl (in diesem Ausführungsbeispiel sechzehn) Elektrodensegmente 38 auf, die kreisförmig angeordnet sind und sich jeweils im Wesentlichen in radialer Richtung erstrecken. Die Elektrodenanordnung 36 ist dabei radial zur Rotationsachse 29 des Bedienelements 28 ausgerichtet. Form und Dimension der Elektrodensegmente 38 entsprechen im Wesentlichen jenen der Elektrode 30 am Bedienelement 28.

Außerdem ist die Trägerplatte 34 möglichst nahe hinter der Bedienblende 10 angeordnet, sodass auch der Abstand der ersten Elektrodenanordnung 36 zur Bedienblende 10 möglichst klein ist. Insgesamt ist somit auch der Abstand zwischen der Elektrode 30 des Bedienelements 28 und der Elektrodenanordnung 36 auf der Trägerplatte 34 möglichst klein gewählt, wobei die Bedienblende 10 dazwischen als Dielektrikum der so gebildeten kapazitiven Sensoranordnung dient.

Die Anzahl der Rastvertiefungen 19 an der Rastbuchse 18 entspricht der Anzahl der Elektrodensegmente 38 der ersten Elektrodenanordnung 36. Außerdem sind die Rastvertiefungen 19 in den gleichen Winkelpositionen wie die Elektrodensegmente 38 vorgesehen.

Die Rasteinrichtung der Erfindung, welche durch die Rastbuchse 18, den Führungskörper 20, die Kugeln 24 und die Federn 26 gebildet ist, verrastet das Bedienelement 28 in vorgegebenen Drehstellungen relativ zur Bedienblende 10. In diesen vorgegebenen Drehstellungen ist die Elektrode 30 am Bedienelement 28 jeweils im Wesentlichen deckungsgleich zu einem Elektrodensegment 38 oder bevorzugter zu mehreren (hier drei) Elektrodensegmenten 38 der ersten Elektrodenanordnung 36 auf der Trägerplatte 34 positioniert.

Je nach Konfiguration der Auswerteschaltung (Hardware und/oder Software) ist es möglich, die absolute Drehstellung des Bedienelements 28, die Drehrichtung des Bedienelements 28 und/oder die relative Drehbewegung des Bedienelements 28 zu erfassen und an die Steuerung des Haushaltsgerätes weiterzugeben.

In einem alternativen Ausführungsbeispiel können auch einige der Rastvertiefungen 19 an der Rastbuchse 18 weggelassen sein. Zum Beispiel ist nur jede zweite oder jede dritte Rastvertiefung: 19 vorhanden. In diesem Fall kann die gleiche erste Elektrodenariordnung 36 ohne Abänderung für verschiedene Drehknebel 12 mit unterschiedlichen Anzahlen von vorgegebenen Drehstellungen verwendet werden.

Wie oben beschrieben, ist der Führungskörper 20 in axialer Richtung an dem Haltestift 14 bzw. der Rastbuchse 18 gehalten. Dabei ist diese Halterung vorzugsweise lösbar ausgestaltet. Da das Bedienelement 28 fest mit dem Führungskörper 20 verbunden ist, kann dieses bei Bedarf gemeinsam mit dem Führungskörper 20 von dem Haltstift abgezogen werden, um zum Beispiel das Bedienelement 28 und die Bedienblende 10 gründlich zu reinigen. Beim Aufsetzen des Bedienelements 28 auf den Haltestift 14 muss dann darauf geachtet werden, dass sich die Federn 26 und die Kugeln 24 in den Aufnahmen 23 des Führungskörpers 20 befinden.

In einer alternativen Ausführungsform kann die Rasteinrichtung anstelle der über Spiralfedern 26 vorgespannten Kugeln 24 auch andere Konstruktionen enthalten. So kann das Verrasten in vorgegebenen Drehstellungen zum Beispiel auch mittels geeigneter Blattfedern realisiert werden.

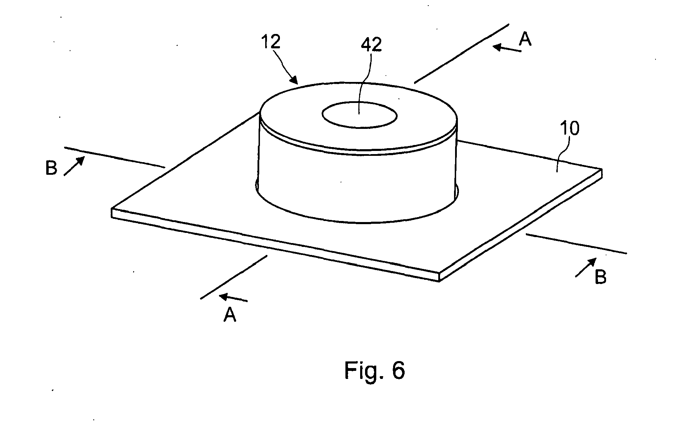

Bezug nehmend auf Fig. 6 bis 9 wird nun ein zweites Ausführungsbeispiel einer erfindungsgemäßen Drehknebel-Bedienvorrichtung näher erläutert. Dabei sind gleiche und entsprechende Komponenten mit den gleichen Bezugsziffern wie im obigen ersten Ausführungsbeispiel gekennzeichnet.

Im Vergleich zu der in Fig. 1 bis 5 dargestellten Drehknebel-Bedienvorrichtung hat die Drehknebel-Bedienvorrichtung 12 dieses Ausführungsbeispiels zusätzlich eine zentrale Drucktaste 42 integriert.

Mit einer solchen Drucktaste 42 kann eine zusätzliche Funktion gesteuert werden. Beispielsweise kann mittels des Bedienelements 28 des Drehknebels 12 durch Drehen ein Waschprogramm der Waschmaschine eingestellt werden und mittels der Drucktaste 42 kann durch Drücken dann dieses Waschprogramm gestartet werden.

Zur Integration der Drucktaste 42 in den Drehknebel 12 weist die Kappe 32 eine mittige Durchbrechung 44 auf. In diese Durchbrechung 44 ist ein Stößel 46 eingesetzt, der sich im Wesentlichen koaxial zur Rotationsachse 29 des Bedienelements 28 in Richtung zur Bedienblende 10 erstreckt.

In diesem Ausführungsbeispiel ist der Stößel 46 zudem mit einer integralen Kappe ausgebildet, welche bei Nichtbetätigung der Drucktaste 42 im Wesentlichen mit der Kappe 32 des Bedienelements 28 fluchtet und die Durchbrechung 44 in der Kappe 32 verschließt. Der Stößel 46 kann aus einem elektrisch leitfähigen Material, beispielsweise Metall, oder aus einem elektrisch nicht leitfähigen Material, beispielsweise Kunststoff, gefertigt sein.

Über den Stößel 46 ist eine Feder 48 geschoben. An seinem der Bedienblende 10 zugewandten Ende ist der Stößel 46 zudem mit einer scheibenförmigen Elektrode 50 versehen. Wenigstens diese Elektrode 50 der Drucktaste 42 ist elektrisch leitfähig ausgebildet oder zumindest an ihrer der Bedienblende 10 zugewandten Unterseite elektrisch leitfähig beschichtet.

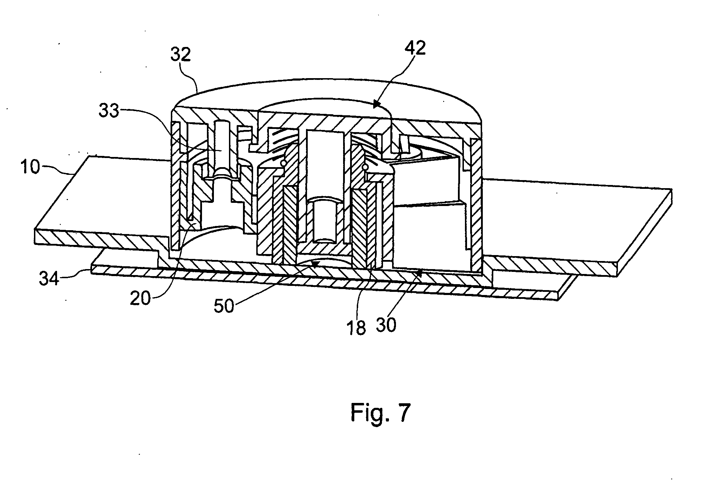

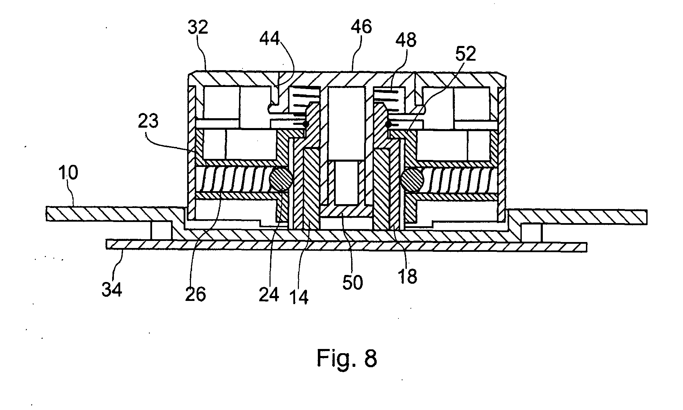

Wie in Fig. 7 und 8 dargestellt, stützt sich die Feder 48 einerseits an der Kappe des Stößels 46 ab und andererseits an einer Abstützfläche 52 am Führungskörper 20. Der Stößel 46 wird auf diese Weise in Richtung der Kappe 32 des Bedienelements 28 vorgespannt, sodass auch die Elektrode 50 am Stößel 46 in Richtung weg von der Bedienblende 10 vorgespannt ist.

Wie in Fig. 7 bis 9 dargestellt, ist im Führungskörper 20 eine zentrale Durchbrechung 54 vorgesehen und ist im Haltstift 14 eine zentrale Durchbrechung 56 vorgesehen. Der Stößel 46 der Drucktaste 42 ragt koaxial zur Rotationsachse 29 des Bedienelements 28 in diese Durchbrechungen 54, 56 hinein.

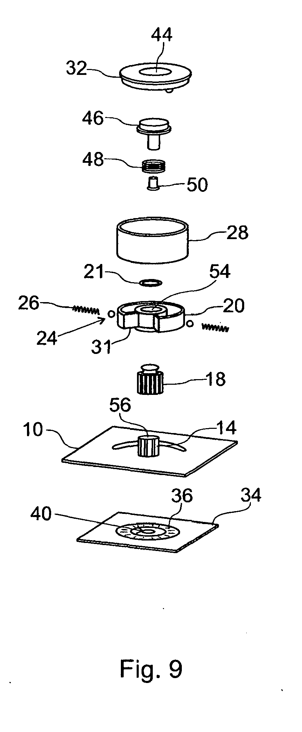

Wie in Fig. 9 veranschaulicht, weist die erste Elektrodenanordnung 36 auf der Trägerplatte 34 neben den Elektrodensegmenten 38 auch eine zentrale Elektrode 40 auf. Diese zentrale Elektrode 40 ist koaxial zur Rotationsachse 29 des Bedienelements 28 und damit auch koaxial zum Stößel 46 der Drucktaste 42 positioniert. Wie in Fig. 9 weiter erkennbar, ist die zentrale Elektrode 40 mehrteilig ausgestaltet, in diesem Ausführungsbeispiel in Form von zwei zueinander beabstandeten, im Wesentlichen halbkreisförmigen Elektrodensegmenten ausgebildet.

Diese zentrale Elektrode 40 der ersten Elektrodenanordnung 36 auf der Trägerplatte 34 bildet zusammen mit der Scheibenelektrode 50 am Stößel 46 und der Bedienblende 10 als Dielektrikum dazwischen eine kapazitive Sensoranordnung. Bei Nichtbetätigung der Drucktaste 42 ist der Stößel 46 durch die Feder 48 in Richtung weg von der Bedienblende 10 vorgespannt, sodass sich ein Luftspalt zwischen der Bedienblende 10 und der Scheibenelektrode 50 der Drucktaste 42 ergibt. Bei Betätigung der Drucktaste 42 drückt der Benutzer den Stößel 46 gegen die Kraft der Feder 48 in den Drehknebel 12 hinein und bewegt so die Scheibenelektrode 50 in Richtung zur Bedienblende 10. Auf diese Weise verändert sich der Kapazitätswert der Sensoranordnung, was von der an die erste Elektrodenanordnung angeschlossene Auswerteschaltung erfasst und ausgewertet werden kann. Je nach Konfiguration der Auswerteschaltung kann auch bereits eine Veränderung des Kapazitätswertes, die allein durch das Berühren der Drucktaste 42 durch den Benutzer verursacht wird, erfasst und ausgewertet werden.

Die Drucktaste 42 bzw. ihr Stößel 46 kann entweder drehfest mit dem Bedienelement 28 oder drehfest mit dem Haltestift 14 konzipiert sein. Mit anderen Worten kann sich die Drucktaste 42 entweder mit dem Bedienelement 28 des Drehknebels 12 mitdrehen oder feststehend ausgestaltet sein.

Die übrigen Merkmale dieser Drehknebel-Bedienvorrichtung 12 entsprechen jenen des oben beschriebenen ersten Ausführungsbeispiels. Auf eine Wiederholung einer detaillierten Erläuterung dieser weiteren Merkmale wird deshalb an dieser Stelle verzichtet.

Obwohl nicht dargestellt, kann in Varianten der obigen Ausführungsbeispiele die Drehknebel-Bedienvorrichtung 12 zusätzlich mit einer Beleuchtung oder Hinterleuchtung versehen sein. Zu diesem Zweck ist auf der Trägerplatte zusätzlich wenigstens eine Lichtquelle zum Beispiel in Form einer Leuchtdiode oder einer Leuchtdiodengruppe angeordnet. Die Bedienblende 10 ist im Bereich des Drehknebels 12 dann zumindest teilweise lichtdurchlässig ausgebildet, sodass das von der Lichtquelle emittierte Licht durch die Bedienblende 10 hindurchdringen kann, ohne dass in dieser ein Durchbruch vorgesehen werden muss. Das Bedienelement ist ebenfalls zumindest teilweise lichtdurchlässig ausgebildet, sodass das von der Lichtquelle emittierte und durch die Bedienblende 10 gelaufene Licht aus dem Bedienelement 28 oder dessen Kappe 32 austreten kann. Alternativ oder zusätzlich enthält das Bedienelement 28 wenigstens ein Lichtleitelement. Durch eine solche Hinterleuchtung des Drehknebels 12 kann dem Benutzer beispielsweise ein Betriebszustand des Haushaltsgerätes oder eine Funktionsbereitschaft des Drehknebels 12 angezeigt werden.

Während in den obigen Ausführungsbeispielen die Rasteinrichtung 18-26 so ausgestaltet ist, dass das Verrasten des Bedienelements 28 in vorgegebenen Drehstellungen in radialer Richtung zwischen dem Bedienelement 28 und dem zentralen Haltestift 14 bzw. der auf diesen aufgesteckten Rastbuchse 16 erfolgt, ist auch ein Verrasten in axialer Richtung, d.h. in einer Richtung parallel zur Rotationsachse 29 des Bedienelements 28 denkbar. So können die mit den Federn 26 vorgespannten Kugeln 24 auch zwischen der der Bedienblende 10 zugewandten Unterseite des Bedienelements 28 oder des Führungskörpers 20 und der Bedienblende 10 selbst angeordnet sein und in Richtung zur Bedienblende 10 vorgespannt sein. In der Vertiefung 16 in der Bedienblende 10 können zum Beispiel entsprechende Rastvertiefungen für die Kugeln 24 ausgebildet sein.

Ein Haushaltsgerät kann mit einer oder mehreren Drehknebel-Bedienvorrichtungen 12 der Erfindung ausgestattet sein. Die ersten Elektrodenanordnungen 36 dieser Drehknebel-Bedienvorrichtungen 12 sind dann vorzugsweise auf einer gemeinsamen Trägerplatte 34 angeordnet und ggf. auch mit einer gemeinsamen Auswerteschaltung gekoppelt.

Falls das Haushaltsgerät weitere berührungs- oder annäherungsempfindliche Bedienelemente enthält, weisen diese vorzugsweise ebenfalls kapazitive Sensoranordnungen auf, sodass ein einheitliches Eingabe- und Auswertekonzept vorhanden ist. Die Elektroden dieser weiteren Bedienelemente sind dann vorzugsweise ebenfalls auf der Trägerplatte 34 angeordnet und ggf. auch mit einer gemeinsamen Auswerteschaltung gekoppelt.

### BEZUGSZIFFERNLISTE

- 10: Bedienblende
- 12: Drehknebel-Bedienvorrichtung, Drehknebel
- 14: Halteeinrichtung, Haltestift
- 16: Vertiefung
- 18: Rastbuchse
- 19: Rastvertiefungen
- 20: Führungskörper
- 21: Federring
- 22: Außenumfangsnut
- 23: Aufnahmen
- 24: Kugeln
- 26: Federn
- 28: ringförmiges Bedienelement
- 29: Rotationsachse von 28
- 30: zweite Elektrodenanordnung, Elektrode
- 31: Ausnehmung
- 32: Kappe
- 33: Rastzapfen
- 34: Trägerplatte, Leiterplatte
- 36: erste Elektrodenanordnung
- 38: Elektrodensegmente
- 40: zentrale Elektrode
- 42: Drucktaste
- 44: Durchbrechung in 32
- 46: Stößel mit Kappe
- 48: Feder
- 50: Elektrode, Scheibenelektrode
- 52: Abstützfläche an 20
- 54: Durchbrechung in 20
- 56: Durchbrechung in 14

## Patentansprüche

1. Drehknebel-Bedienvorrichtung, insbesondere für ein elektrisches Haushaltsgerät, mit einem im Wesentlichen ringförmigen Bedienelement (28) auf einer dem Benutzer zugewandten Seite einer Bedienblende (10); einer Halteeinrichtung (14) zum Halten des Bedienelements (28) an der Bedienblende (10), wobei das Bedienelement (28) um eine im Wesentlichen senkrecht zur Bedienblende verlaufende Rotationsachse (29) drehbar ist; und eine Rasteinrichtung (18-26) zum Verrasten des Bedienelements (28) relativ zur Bedienblende (10) in mehreren vorgegebenen Drehstellungen, **gekennzeichnet durch**,
einer Trägerplatte (34) auf einer dem Benutzer abgewandten Seite der Bedienblende (10);
einer auf der Trägerplatte (34) vorgesehenen ersten Elektrodenanordnung (36); und
einer an dem Bedienelement (28) vorgesehenen zweiten Elektrodenanordnung (30).

2. Drehknebel-Bedienvorrichtung nach Anspruch 1,
**dadurch gekennzeichnet, dass**
die durch die Rasteinrichtung (18-26) bewirkte Verrastung des Bedienelements (28) relativ zur Bedienblende (10) im Wesentlichen radial oder im Wesentlichen axial erfolgt.

3. Drehknebel-Bedienvorrichtung nach Anspruch 1 oder 2,
**dadurch gekennzeichnet, dass**
die Rasteinrichtung (18-26) wenigstens ein elastisches oder elastisch gelagertes Rastelement (24) aufweist.

4. Drehknebel-Bedienvorrichtung nach einem der vorhergehenden Ansprüche,
**dadurch gekennzeichnet, dass**
die erste Elektrodenanordnung (36) auf der Trägerplatte (34) eine zentrale Elektrode (40) aufweist; und
in dem Bedienelement (28) im Wesentlichen koaxial zur Rotationsachse des Bedienelements (28) eine Drucktaste (42) angeordnet ist, welche im Wesentlichen in Richtung der Rotationsachse (29) des Bedienelements bewegbar ist und an ihrer der Bedienblende (10) zugewandten Seite wenigstens eine Elektrode (50) aufweist.

5. Drehknebel-Bedienvorrichtung nach einem der vorhergehenden Ansprüche,
**dadurch gekennzeichnet, dass**
auf der Trägerplatte (34) wenigstens eine Lichtquelle angeordnet ist;
die Bedienblende (10) zumindest teilweise lichtdurchlässig ausgebildet ist; und
das Bedienelement (28) zumindest teilweise lichtdurchlässig ausgebildet ist und/oder wenigstens ein Lichtleitelement enthält.

6. Drehknebel-Bedienvorrichtung nach einem der vorhergehenden Ansprüche,
**dadurch gekennzeichnet, dass**
die erste Elektrodenanordnung (36) auf der Trägerplatte (34) mehrere Elektrodensegmente (38) aufweist, die im Wesentlichen koaxial zur Rotationsachse (29) des Bedienelements (28) angeordnet sind.

7. Drehknebel-Bedienvorrichtung nach einem der vorhergehenden Ansprüche,
**dadurch gekennzeichnet, dass**
die zweite Elektrodenanordnung (30) am Bedienelement (28) wenigstens eine Elektrode (30) aufweist, die sich im Wesentlichen radial zur Rotationsachse (29) des Bedienelements (28) erstreckt.

8. Drehknebel-Bedienvorrichtung nach einem der vorhergehenden Ansprüche,
**dadurch gekennzeichnet, dass**
das Bedienelement (28) mittels der Halteeinrichtung (14) lösbar an der Bedienblende (10) gehalten ist.

9. Elektrisches Haushaltsgerät mit wenigstens einer Drehknebel-Bedienvorrichtung (12) nach einem der Ansprüche 1 bis 8.

10. Haushaltsgerät nach Anspruch 9,
**dadurch gekennzeichnet, dass**
wenigstens ein berührungs- oder annäherungsempfindliches Bedienelement mit einer kapazitiven Sensoranordnung vorgesehen ist, wobei eine Elektrode der kapazitiven Sensoranordnung auf der gleichen Trägerplatte (34) wie die erste Elektrodenanordnung (36) der Drehknebel-Bedienvorrichtung (12) vorgesehen ist.

## Claims

1. Rotary knob operator control apparatus, in particular for an electrical domestic appliance, having a substantially annular operator control element (28) on a side of an operator control panel (10) which faces the user;
a holding device (14) for holding the operator control element (28) on the operator control panel (10), wherein the operator control element (28) can be rotated about a rotation axis (29) which runs substantially perpendicular to the operator control panel; and
a latching device (18-26) for latching the operator control element (28) relative to the operator control panel (10) in a plurality of predefined rotary positions, **characterized by**
a mounting board (34) on a side of the operator control panel (10) which is averted from the user;
a first electrode arrangement (36) which is provided on the mounting board (34); and
a second electrode arrangement (30) which is provided on the operator control element (28).

2. Rotary knob operator control apparatus according to Claim 1,
**characterized in that**
the latching of the operator control element (28) relative to the operator control panel (10), which latching is effected by the latching device (18-26), is performed in a substantially radial manner or in a substantially axial manner.

3. Rotary knob operator control apparatus according to Claim 1 or 2,
**characterized in that**
the latching device (18-26) has at least one elastic or elastically mounted latching element (24).

4. Rotary knob operator control apparatus according to one of the preceding claims,
**characterized in that**
the first electrode arrangement (36) has a central electrode (40) on the mounting board (34); and
a pushbutton (42) is arranged in the operator control element (28) substantially coaxially to the rotation axis of the operator control element (28), and can be moved substantially in the direction of the rotation axis (29) of the operator control element, and has at least one electrode (50) on its side which faces the operator control panel (10).

5. Rotary knob operator control apparatus according to one of the preceding claims,
**characterized in that**
at least one light source is arranged on the mounting board (34);
the operator control panel (10) is designed to be at least partially transparent; and
the operator control element (28) is designed to be at least partially transparent and/or contains at least one light guide element.

6. Rotary knob operator control apparatus according to one of the preceding claims,
**characterized in that**
the first electrode arrangement (36) has a plurality of electrode segments (38) on the mounting board (34), the said electrode segments being arranged substantially coaxially to the rotation axis (29) of the operator control element (28).

7. Rotary knob operator control apparatus according to one of the preceding claims,
**characterized in that**
the second electrode arrangement (30) has at least one electrode (30) on the operator control element (28), the said electrode extending substantially radially to the rotation axis (29) of the operator control element (28).

8. Rotary knob operator control apparatus according to one of the preceding claims, **characterized in that** the operator control element (28) is held in a detachable manner on the operator control panel (10) by means of the holding device (14).

9. Electrical domestic appliance having at least one rotary knob operator control apparatus (12) according to one of Claims 1 to 8.

10. Domestic appliance according to Claim 9,
**characterized in that**
at least one touch- or proximity-sensitive operator control element is provided with a capacitive sensor arrangement, wherein an electrode of the capacitive sensor arrangement is provided on the same mounting board (34) as the first electrode arrangement (36) of the rotary knob operator control apparatus (12).

## Revendications

1. Dispositif de commande à manette rotative, notamment pour un appareil électroménager, avec :
un élément de commande (28) pour l'essentiel en forme d'anneau placé sur un côté d'un bandeau de commande (10) orienté vers l'utilisateur ;
un dispositif de maintien (14) servant à maintenir l'élément de commande (28) au niveau du bandeau de commande (10), l'élément de commande (28) pouvant pivoter autour d'un axe de rotation (29) s'étendant pour l'essentiel perpendiculairement au bandeau de commande ; et
un dispositif d'encliquetage (18-26) permettant d'encliqueter l'élément de commande (28) par rapport au bandeau de commande (10) dans plusieurs positions de pivotement prédéfinies ;
**caractérisé par** :
une plaque de support (34) prévue sur un côté du bandeau de commande (10) opposé à l'utilisateur ;
un premier agencement d'électrode (36) prévu sur la plaque de support (34) ;
un deuxième agencement d'électrode (30) prévu sur l'élément de commande (28).

2. Dispositif de commande à manette rotative selon la revendication 1, **caractérisé en ce que** l'encliquetage de l'élément de commande (28), réalisé par le biais du dispositif d'encliquetage (18-26), se produit pour l'essentiel dans le plan radial ou pour l'essentiel dans le plan axial par rapport au bandeau de commande (10).

3. Dispositif de commande à manette rotative selon la revendication 1 ou 2, **caractérisé en ce que** le dispositif d'encliquetage (18-26) comporte au moins un élément d'encliquetage (24) élastique ou disposé de façon élastique.

4. Dispositif de commande à manette rotative selon l'une quelconque des revendications précédentes, **caractérisé en ce que** :
le premier agencement d'électrode (36) comporte une électrode centrale (40) sur la plaque de support (34) ; et
une touche de pression (42) est disposée dans l'élément de commande (28) pour l'essentiel dans le plan coaxial par rapport à l'axe de rotation de l'élément de commande (28), ladite touche pouvant être déplacée pour l'essentiel en direction de l'axe de rotation (29) de l'élément de commande et comportant au moins une électrode (50) au niveau de son côté orienté vers le bandeau de commande (10).

5. Dispositif de commande à manette rotative selon l'une quelconque des revendications précédentes, **caractérisé en ce que** :
au moins une source lumineuse est disposée sur la plaque de support (34) ;
le bandeau de commande (10) est réalisé au moins en partie de façon translucide ; et
l'élément de commande (28) est réalisé au moins en partie de façon perméable à la lumière et/ou contient au moins un élément conducteur de lumière.

6. Dispositif de commande à manette rotative selon l'une quelconque des revendications précédentes, **caractérisé en ce que** le premier agencement d'électrode (36) comporte plusieurs segments d'électrode (38) sur la plaque de support (34) disposés pour l'essentiel dans le plan coaxial par rapport à l'axe de rotation (29) de l'élément de commande (28).

7. Dispositif de commande à manette rotative selon l'une quelconque des revendications précédentes, **caractérisé en ce que** le deuxième agencement d'électrode (30) comporte au moins une électrode (30) au niveau de l'élément de commande (28), ladite électrode s'étendant pour l'essentiel dans le plan radial par rapport à l'axe de rotation (29) de l'élément de commande (28).

8. Dispositif de commande à manette rotative selon l'une quelconque des revendications précédentes, **caractérisé en ce que** l'élément de commande (28) est maintenu de façon amovible au niveau du bandeau de commande (10) à l'aide du dispositif de maintien (14).

9. Appareil électroménager doté d'au moins un dispositif de commande à manette rotative (12) selon l'une quelconque des revendications 1 à 8.

10. Appareil électroménager selon la revendication 9, **caractérisé en ce qu'**au moins un élément de commande sensible au contact ou à une approche est pourvu d'un agencement de capteur capacitif, une électrode de l'agencement de capteur capacitif étant prévue sur la même plaque de support (34) que le premier agencement d'électrode (36) du dispositif de commande à manette rotative (12).
